**Europäisches Patentamt**

**European Patent Office**

**Office européen des brevets**

(11) Publication number: **0 103 971**
**B1**

# (12) EUROPEAN PATENT SPECIFICATION

(45) Date of publication of patent specification: **14.01.87**

(21) Application number: **83304585.9**

(22) Date of filing: **09.08.83**

(51) Int. Cl.⁴: **G 01 R 31/02**

(54) **Apparatus for testing wiring harnesses.**

(30) Priority: **18.08.82 GB 8223799**

(43) Date of publication of application:
**28.03.84 Bulletin 84/13**

(45) Publication of the grant of the patent:
**14.01.87 Bulletin 87/03**

(84) Designated Contracting States:
**DE FR GB**

(56) References cited:
**DE-B-2 547 938**
**US-A-4 257 002**

**ELEKTRONIK, vol. 29, no. 10, May 1980,**
**München P. SCHOLZ "Der automatische**
**Kurzschluss- und Verdrahtungstest", pages**
**78-80**

**ELEKTRONIKPRAXIS, vol. 5, nos. 7/8, August**
**1976 N. MILKOVIC "Verdrahtungstester - ein**
**Spezialgebiet der Netzwerkanalyse", pages**
**79-83**

(73) Proprietor: **LUCAS INDUSTRIES public limited**
**company**
**Great King Street**
**Birmingham, B19 2XF West Midlands (GB)**

(72) Inventor: **Atkins, David Steven**
**8 Pear Tree Drive**
**Madeley Nr Crewe Cheshire (GB)**

(74) Representative: **Prutton, Roger et al**
**MARKS & CLERK Alpha Tower Suffolk Street**
**Queensway**
**Birmingham B1 1TT (GB)**

## Description

This invention relates to an apparatus for testing wiring harnesses.

DE—B—2547938 discloses an automatic test procedure for testing wiring harnesses in which only open circuit faults are searched for. If it is also required to detect faults involving erroneous cross-connection or shorting of two wires together great difficulties arise. Where such detection is required the prior art proposals have involved connecting a supply to one end of a wire in the harness and then testing the other ends of all the wires sequentially. Where there are say 500 wires in the harness the number of test steps required is $(500)^2$ which takes a very long time to carry out.

It is an object of the invention to provide a test apparatus in which such tests can be carried out conveniently and relatively rapidly.

A test apparatus in accordance with the invention comprises a plurality of test circuits one for each wire in the harness, and each comprising a first switch device for connecting one end of the associated wire to one pole of a power supply and a second switch device for connecting the other end of said wire to the other pole of the power supply, characterised in that each test circuit also comprises a resistor for connection between said other end of said wire and the second switch device, a third switch device connecting the junction of the wire and the resistor to a first common output terminal to which the third switch devices of all the test circuits are connected, and diode means connecting the junction of the resistor and the second switch device to a second common output terminal to which the diode means of all the test circuits are connected and further characterised by a sequential control means for operating the first, second and third switch devices so that all the switch devices associated with a single wire are operated simultaneously, signals provided at said first and second common output terminals indicating the condition of each wire in turn.

In such a system, assuming the first pole of the supply to be a positive voltage and the second to be ground, a normal correct wire will, on test, provide a high signal at the first common output terminal and a low signal at the second common output terminal. In the event of an open circuit fault in the wire both outputs will be low. If there is a short circuit between two wires both outputs will be high and in the event of a crossed connection there will be a low signal at the first common output terminal and a high signal at the second common output terminal. In this way it is a simple matter to distinguish between different types of fault condition without multiplying the number of test stages required as in the prior art.

Preferably, third switch means comprises an analog switch device and the voltage at the first common output terminal can then be detected to determine whether the resistance of a wire is excessive.

Since wiring harnesses frequently contain branched wires, provision is made to ensure that proper testing of these can be carried out. In the case of a branched wire having several ends, one end is connected to the resistor of one test circuit, one of the other ends is connected to· the first switch device of the same test circuit and the remaining ends are connected to the first switch devices of the circuits which follow the aforesaid one test circuit in the sequence. The sequential control is arranged so that instead of operating the first, second and third switch devices in the normal sequence, the second and third switch devices of said one test circuit remain operated for the required several steps of the sequence, whilst the first switch device of the several test circuits involved are operated in the normal sequence.

The sequential control device preferably includes a memory in which there is stored connection data for all the wires of the harness so that "normal" and "branched" sequential stepping can take place automatically during the test procedure.

An example of the invention is shown somewhat diagrammatically in the accompanying drawings in which:—

Figure 1 is an overall block diagram of one example of an apparatus in accordance with the invention;

Figure 2 is a block diagram of a part of a control circuit employed in the apparatus of Figure 1;

Figure 3 is a block diagram of another part of the control circuit;

Figure 4 is a diagram of an output board select circuit included in the apparatus of Figure 1;

Figure 5 is a circuit diagram of one of a plurality of output boards which are employed in the apparatus of Figure 1; and

Figure 6 is a more detailed electrical circuit diagram of one of the sixteen test circuits which are included in the output board circuit shown in Figure 5.

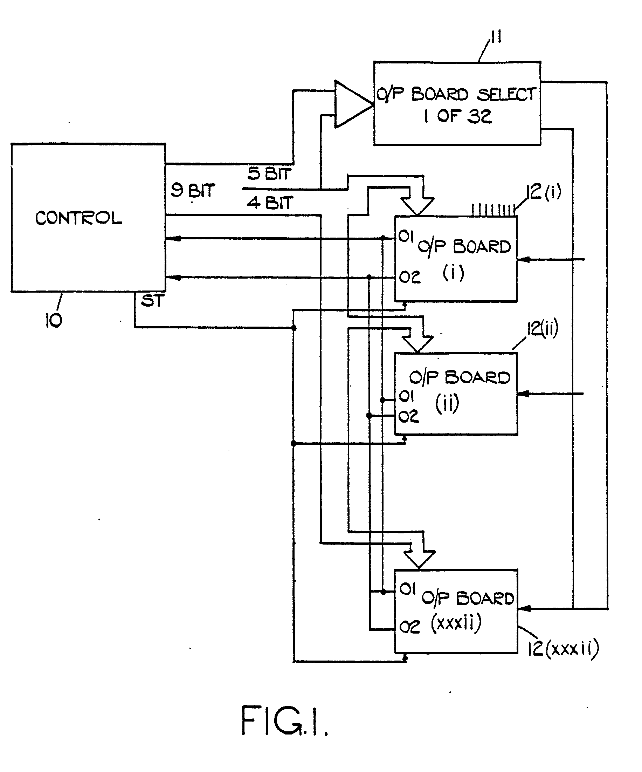

Referring firstly to Figure 1, the apparatus shown includes a main control 10 which both determines which one of the wires of the harness is to be tested at any given instant and also receives back a two bit signal related to each wire. The control 10 produces a 9-bit binary wire address code with the address code being incremented by one on every clock interval as will be explained in more detail hereinafter. The control 10 also produces an 'ST' code signal indicating when the wire under test is part of a branched wire in the harness.

The most significant 5 bits of the 9 bit address code are supplied to an output board select circuit 11 which is effectively a 5 bit binary to one of thirty two converter. This in turn selects which of thirty-two output boards 12(i), 12(ii) ... (12(xxxii) is operative at any given instant and each such output board receives the 4 l.s.b.s. of the address code to select one of the sixteen wires associated with that output board. The 'ST' signal is also supplied to each output board. Each output board

has an $O_1$ output and an $O_2$ output and the $O_1$ outputs of all the boards are connected to a first common output, whilst the $O_2$ outputs are all connected to a second common output, the common outputs being connected to the control circuit 10.

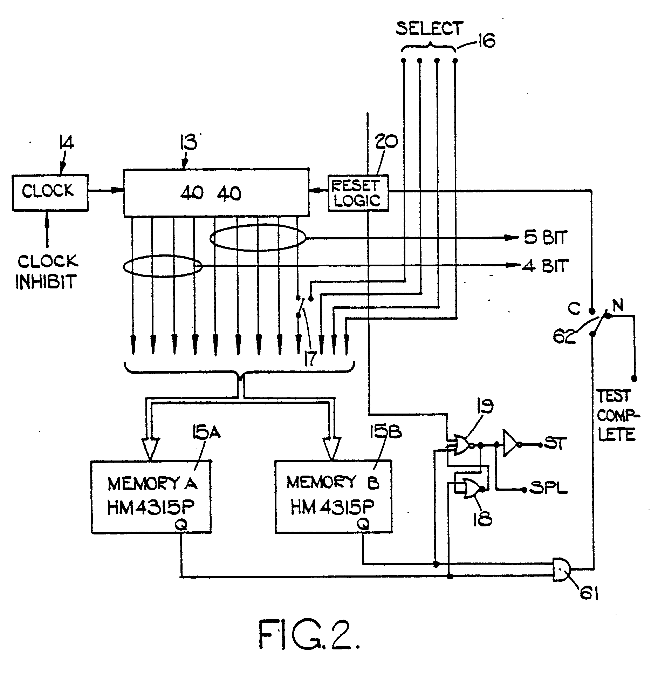

Turning now to Figure 2, the part of the control 10 shown is intended to produce the 9 bit address signal and also the 'ST' signal referred to above. For generating the address signal there is provided a counter 13 which counts pulses from a clock 14. The clock 14 has a terminal for receiving an inhibit signal for a purpose to be described. Inter alia, the 9 bit address signal is fed to a memory consisting of two 4096 × 1 bit memory integrated circuits 15A and 15B which together provide a two bit output for each address. In fact the memory capacity provided by these integrated circuits is sufficient to store data relating to eight different harness designs, each consisting of up to 512 wires, or sixteen different harness designs each consisting of up to 256 wires. Figure 2 shows a group of terminals 16 marked "Select". These are used to supplement the address code generated by the counter 13 to make up a complete address code consisting of 12 bits. For eight 512 wire harnesses three extra bits are added. For sixteen 256 wire harnesses, the m.s.b. of the 9-bit output of the counter 13 is not used, but a switch 17 is employed to select an additional one of the 'Select' terminals 16.

Programming of the memory, which preferably employs integrated circuits type HM4315P, is carried out in the control circuit which has a keyboard and other control circuitry (not shown) for this purpose. Suffice it to say that for normal wires having only two ends, both memory devices 15A and 15B are programmed with a zero. For a branched wire at the first address in the count sequence corresponding to the branched wire, the memory devices 15A and 15B are programmed '1' and '0' respectively. At the address following the last address of that branched wire the devices 15A and 15B are coded '0' and '1' respectively and at intermediate address and devices 15A, 15B can be programmed either '1' and '0' or '0' and '0' respectively. At the address following the last address in the entire sequence the memory devices are both programmed with a '1' and this is used, as will be explained, to stop the test.

While the test is actually running, the memory devices 15A, 15B output signals corresponding to the stored data for each wire address. The Q output of memory device 15A is connected to one terminal of a two input NOR gate 18, the other input of which is connected to the output of a three input NOR gate 19. The output of the gate 18 is connected to an input of the gate 19, which has another input connected to the Q output of memory device 15B and its third input connected to a logic circuit 20, the detail of which is irrelevant to the present invention. The two NOR gates 18 and 19 act as a flip-flop circuit which is initially set by a pulse from circuit 20 so that the output of gate 19 is low and that of gate 18 high (thereby holding the output of gate 19 low). When the memory devices output the 10 signal at the commencement of the group of addresses relating to a branched wire, the output of gate 18 goes low and the output of gate 19 goes high, thereby causing the output of gate 18 to remain low when the 10 output disappears. When the 01 signal appears from the memory devices the output of gate 19 goes low and the flip-flop circuit changes back to its original state. The gate 19 output is connected to an SPL terminal and to the input of an inverter, the output of which is connected to an ST terminal.

The Q outputs of memories 15A and 15B are also connected to the two inputs of an AND gate 61, the output of which is connected to the input terminal of a switch 62. The switch 62 has an output terminal C which is connected to the logic 20 and an output terminal N.

When performing a normal test sequence, the switch 62 is in the "N" position. When the test is complete, the output of AND gate 61 goes high and the resulting high signal at the terminal N of switch 62 is used to stop the test and to indicate that the test is complete.

The apparatus may also be used to test a harness wire by wire as it is being laid up. In this case, the apparatus is operated continuously and in order to achieve this the switch 62 is put into the "C" position. With switch 62 in this position, at the end of each sequence a high signal is provided via switch 62 to logic 20 which restarts the test sequence unless all the cables have been laid up and tested succesfully. If this is the case the test is terminate at the test complete signal is activated.

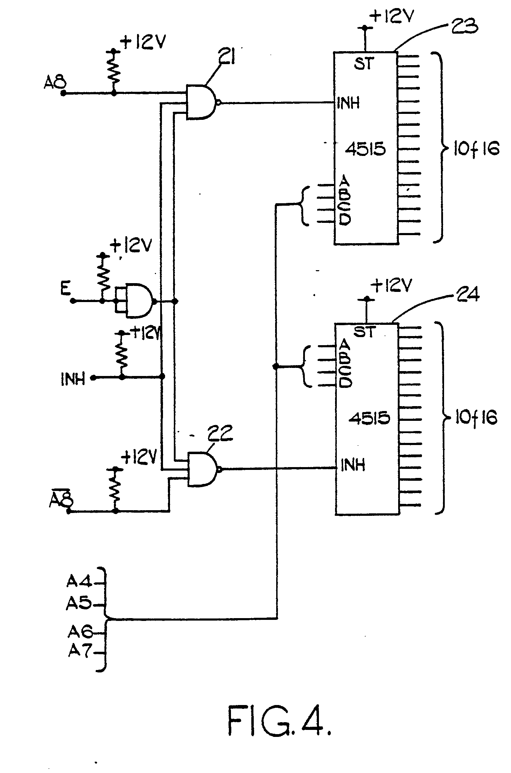

Turning now to Figure 4, there is shown therein selection circuit 11 of Figure 1 in detail. As explained in the description of Figure 1 above, the circuit 11 receives a 5 bit input shown in Figure 4 as inputs $A_4$ to $A_8$, an additional input $A_8$ being provided. In addition the circuit has two further inputs marked E and INH from the control circuit, but these inputs are of no significance in the context of the description of the present invention, but merely operate to inhibit the board selection circuit 11 completely in certain circumstances. Two NAND gates 21 and 22 combine the $A_8$ and $A_8$ signals respectively with the E and INH signals. The circuit 11 includes two 4 bit binary to 1-of-16 converter circuits 23, 24 which each receive the 4 bit input $A_4$ to $A_7$ as data inputs and which respectively receive, at their INH input terminals the output of the gates 21 and 22. Thus the circuit 11 operates, as described above, as a 5 bit to 1-of-32 converter. The integrated circuit converters 23, 24 are CMOS integrated circuits type 4515, which are such that the signal at the output terminal identified by the binary input signal is low, the remainder being high. These circuits also include a 4 bit input latch, but the ST (strobe) input of each is connected to the positive supply rail so that the latch is not, in fact, being used as a latch. When the signal to the INH input of either circuit 23, 24 is high, all the outputs of that circuit are high.

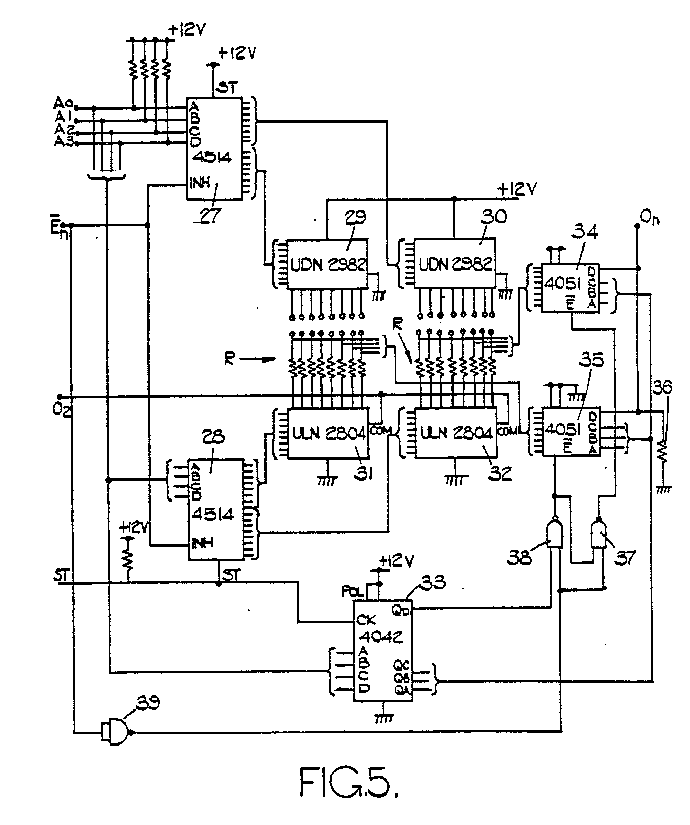

Turning now to Figure 5 one of the thirty two output boards 12(i) to 12(xxxii) is shown in detail therein. This board contains at its inputs two CMOS type 4514 integrated circuit 4 bit binary of 1-of-16 output converters 27 and 28. The data inputs of these circuits 27, 28 are connected to the 4 l.s.b. output of the counter 13 and the circuits are such that all of the outputs of each are low except for the one identified by the input word. Each board has an input En from one of the thirty two outputs of circuit 11 and this input is connected to the INH inputs of the two circuits 27, 28. It will be recalled that, in operation, only one of the outputs of circuit 11 is low at any given time and it is only the board which is connected to this particular output which is enabled. On the remaining boards, all the outputs of the circuits 27 and 28 are low.

The input latches in the circuit 27 are overridden by virtue of connection of the ST (strobe) input thereof to the positive supply rail. The circuit 28, however, has its ST (strobe) input, connected to the ST output terminal of the control circuit 10. Hence the output of circuit 27 (when not inhibited) is always determined by the data input thereto, but the output of circuit 28 is only so determined when the ST signal is high, i.e. at all times except when the current address relates to a branched wire, the address code existing when the ST signal goes low being latched in until the ST signal goes high again.

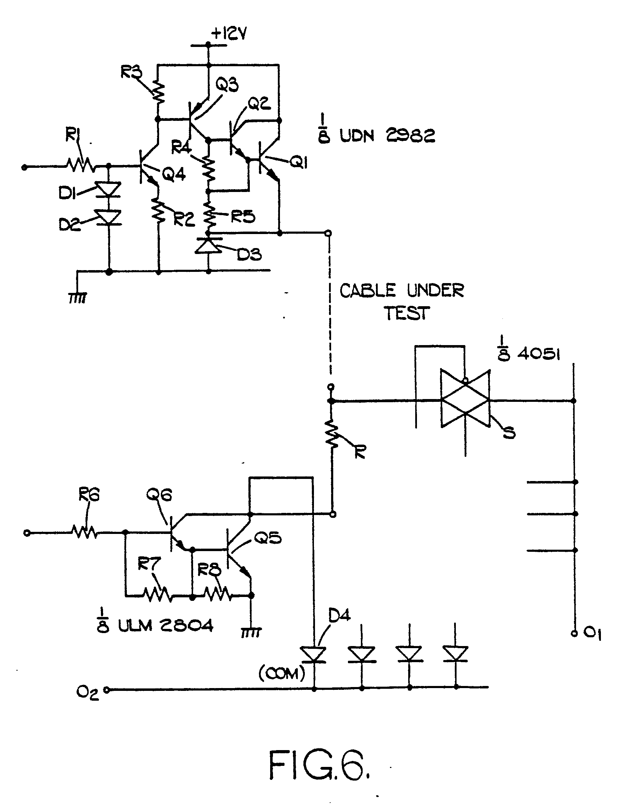

The outputs of circuit 27 are connected respectively to the inputs of two integrated circuit Darlington arrays 29, 30 (type UDN-2982 manufactured by Sprague Eléctric, Salbrook Road, Salbrook, Redhill, Surrey, RH1 5DZ). Each of these integrated circuits contains eight Darlington pairs and drive components therefore, each as shown in the upper left hand part of Figure 6.

Similarly, the sixteen outputs of circuit 28 are connected to two integrated circuit Darlington arrays 31, 32 (type ULN 2804 manufactured by Sprague Electric at the address recited above). Each of these contains eight Darlington pairs, each as shown in the bottom left hand part of Figure 6.

The 4 bit address signal is also applied to the data inputs of a latch circuit 33, which is a CMOS integrated circuit type 4042. The CLOCK input of circuit 33 is connected to the ST terminal and the POLARITY input thereof is connected to the positive supply. The latch thus operates in exactly the same manner as the input latch of circuit 28.

The $Q_A$, $Q_B$ and $Q_C$ outputs of circuit 33 are connected to the data inputs of two CMOS type 4051 integrated circuit analog multiplexers 34, 35. Eight resistors R connect the signal inputs of multiplexer 35 to the circuit 31 and eight more resistor R connect the signal inputs of multiplexer 34 to the circuit 32. The signal outputs of the two multiplexers 34, 35 are connected to the output terminal $0_1$ and are also connected by a load resistor 36 to ground. The inhibit 10(E) inputs of the multiplexers 34, 35 are controlled respectively by two NAND gates 37, 38. Both of these gates have one input from a NAND gate 39 connected as an inverter and receiving its input from terminal En. Gate 38 receives a second input from out $Q_D$ of latch 33 and gate 37 receives its other input from gate 38.

Figure 6 shows one channel of the circuit shown in Figure 5 in more detail. The upper left hand part is one channel of one of the circuits 29 or 30. This consists of an output npn Darlington pair $Q_1$, $Q_2$, a pnp driver transistor $Q_3$ and an npn input transistor $Q_4$. The channel control input of the circuit is connected by a resistor $R_1$ to the base of transistor $Q_4$, this base being connected to a ground terminal of the device by two diodes $D_1$, $D_2$ in series. The emitter of the transistor $Q_4$ is connected by a resistor $R_2$ to the ground terminal. The collector of transistor $Q_4$ is connected by a resistor $R_3$ to a +ve supply terminal and is also connected to the base of the transistor $Q_3$ the emitter of which is connected to the supply terminal. The collector of the transistor $Q_3$ is connected by two resistors $R_4$, $R_5$ in series to the emitter of the transistor $Q_1$, the junction of these resistors being connected to the emitter of the transistor $Q_2$. The collector of transistors $Q_1$ and $Q_2$ are connected to the supply and the emitter of the transistor $Q_1$ provides the channel output. A diode $D_3$ included in the circuit between the emitter of the transistor $Q_1$ and ground has no effect in the circuit when used in the present application, but is present to provide "freewheel" action when the circuit is used in its intended application of driving inductive loads.

The corresponding channel S of one of the circuits 31, 32 is shown in the bottom left hand part of Figure 6. The circuit in this case is much simpler, including as it does just an npn Darlington pair $Q_5$, $Q_6$ with their collectors connected to the channel output terminal and the emitter of transistor $Q_5$ connected to a ground terminal. Three resistors $R_6$, $R_7$ and $R_8$ are connected in series between the channel input terminal and ground, the junctions of these resistors being connected to the base of transistor $Q_6$ and the base of transistor $Q_5$ respectively. The "freewheel" diode $D_4$ in this case is connected between each channel output terminal and a common terminal of each circuit 31, 32 which is connected to the output terminal $0_2$.

As shown the appropriate analog multiplex channel S is connected in series with the resistor R between the channel output of the circuits 31 or 32 and the output terminal $0_1$.

When the harness is connected to the test apparatus, a single wire of the harness completes the test circuit of Figure 6. When the address of that particular wire is generated transistors $Q_1$ and $Q_5$ become conductive and the analog channel also becomes conductive. if there is a normal, sound connected between the wire ends the output at $0_1$ is high, but that at $0_2$ is low. If the wire is not properly connected, i.e. there is an open circuit, $0_1$ and $0_2$ will both be low, as there is no current flowing in the resistor R. If the wire under test is cross-connected, there will be a low signal at terminal $0_1$, because there will be no current in the addressed test circuit, but the signal at terminal $0_2$ will be high, because voltage will be applied to a non-selected (off) transistor $Q_5$ of a different test circuit. If both $0_1$ and $0_2$ are high this indicates a short-circuit between two wires, because, as in the case of a cross-connection voltage will be applied to a *non-selected* test circuit as well as current in the selected test circuit being detected.

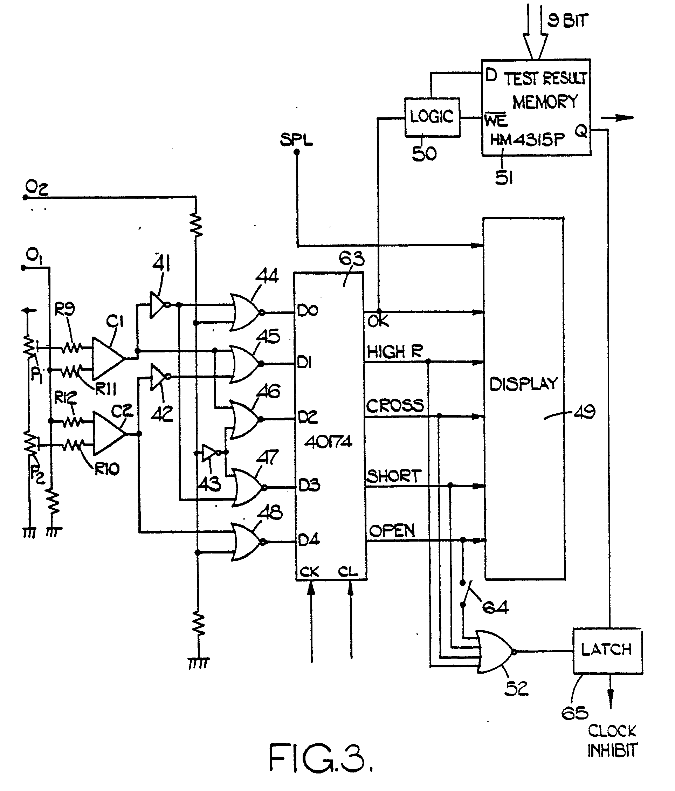

Figure 3 shows the part of the control circuit which receives and processes the $O_1$ and $O_2$ signals. Two voltage comparators $C_1$ and $C_2$ are connected to compare the $O_1$ signal with adjustable upper and lower reference voltage derived from two potentiometers $P_1$ and $P_2$ in series. Resistors $R_9$, $R_{10}$ connect the inverting inputs of the comparators to the sliders of the respective potentiometers. Resistors $R_{11}$, $R_{12}$ connect the non-inverting inputs to the $O_1$ terminal. The outputs of comparators $C_1$ and $C_2$ are combined in various combinations with the $O_2$ signal in a logic circuit consisting of three inverters 41, 42, 43 and five two input NOR gates 44 to 48. Gate 44 has its inputs from $O_2$ and the inverter 41 which is driven by the comparator $C_1$. Gate 44 detects the OK condition. Gate 45 has one input connected to the output of comparator $C_1$ and the other connected to the output of inverter 42 which is driven by the comparator $C_2$. Gate 45 detects a "high resistance" condition. Gate 46 has one input connected to the output of comparator $C_1$ and the other connected to the output of the inverter 43, which is driven by the $O_2$ terminal. Gate 46 detects the cross connection condition. Gate 47 has inputs from the inverters 41 and 43 and detects the short circuit condition. Finally gate 48 has inputs from the comparator $C_2$ and the terminal $O_2$ and detects the open circuit condition. The outputs of gates 44 to 48 are connected to the inputs of a latch circuit 63 (CMOS i.c. type 40714) which provides driving signals to a display module 49. An output is taken from the latch 63 to a logic circuit 50 which controls loading of a test result memory 51 which receives the 9 bit address signal. A '1' is entered at every address in respect of which an 'O.K.' signal is produced.

The "high resistance" condition output, the "cross connection" output and the "short circuit" output of latch 63 are connected to three inputs of a NOR gate 52 and the "open circuit" condition output is fed to the fourth input of NOR gate 52 via a switch 64. The output of NOR gate 52 is fed to the set input of a latch 65. The Q output of memory 51 is fed to the reset input of latch 65 and the output of latch 65 provides the inhibit signal for clock 14.

During normal operation switch 64 is closed. If a fault is detected latch 65 is set thereby inhibiting the test procedure. When the fault is corrected, the output of memory 51 goes high thereby resetting latch 65 and permitting the test to continue.

When the apparatus is used to test a harness as it is being laid-up, switch 64 is opened. The apparatus then operates continuously as previously described and, because switch 64 is open, the open circuit condition of uncompleted wires does not cause latch 65 to be set. However, if a fault other than an uncompleted wire is detected, latch 65 is set and the test is interpreted as previously described.

In either type of test, when a "1" has been entered at each address in memory 51, circuitry not shown connected to memory 51 produces a signal to indicate that the harness is complete and free from faults.

**Claims**

1. Apparatus for testing wiring hardnesses comprising a plurality of test circuits one for each wire in the harness, and each comprising a first switch device ($Q_1$) for connecting one end of the associated wire to one pole of a power supply and a second switch device ($Q_5$) for connecting the other end of said wire to the other pole of the power supply, characterised in that each test circuit also comprises a resistor (R) for connection between said other end of said wire and the second switch device ($Q_5$), a third switch device (S) connecting the junction of the wire and the resistor (R) to a first common output terminal ($O_1$) to which the third switch devices (S) of all the test circuits are connected, and diode means ($D_4$) connecting the junction of the resistor (R) and the second switch device ($Q_5$) to a second common output terminal ($O_2$) to which the diode means of all the test circuits are connected and further characterised by a sequential control means for operating the first, second and third switch devices so that all the switch devices associated with a single wire are operated simultaneously, signals provided at said first and second common output terminals indicating the condition of each wire in turn.

2. Apparatus as claimed in claim 1 in which said third switch device(s) is an analog switch device so that a test of the resistance of the wire can be made.

3. Apparatus as claimed in claim 2 in which said second common output terminal is connected to a voltage window detector ($C_1$, $C_2$, 42, 45) to sense whether the voltage thereon is within prescribed limits.

4. Apparatus as claimed in any preceding claim including a sequence control memory in which there is stored connection data for all the wires of the harness so that "normal" and "branched" sequential stepping can take place automatically during the test procedure.

5. Apparatus as claimed in any preceding claim in which there is provided a test result memory in which test results can be stored in sequential for subsequent read-out of results.

## Patentansprüche

1. Apparatur zum Testen von Kabelbäumen mit einer Mehrzahl von Testschaltkreisen, nämlich je einem für jeden Leiter im Kabelbaum, von dene jeder eine erste Schaltvorrichtung ($Q_1$) zur Verbindung des einen Endes des zugenordneten Leiters mit dem einen Pol einer Stromquelle und eine zweite Schaltvorrichtung ($Q_5$) zur Verbindung des anderen Endes dieses Leiters mit dem anderen Pol der Stromquelle umfaßt, dadurch gekennzeichnet, daß jeder Testschaltkreis weiterhin eine Widerstand (R) zur Verbindung mit dem besagten anderen Ende der Leitung und der zweiten Schaltvorrichtung ($Q_5$) umfaßt, wobei eine Dritte Schaltvorrichtung (S) die Anschlußstelle der Leitung an den Widerstand mit einer ersten gemeinsamen Ausgangsklemme ($O_1$) verbindet, an welche die Dritten Schaltvorrichtungen (S) aller Testschaltkreise angeschlossen sind, und wobei eine Diodeneinrichtung ($D_4$) die Anschlußstelle des Widerstands (R) an die zweite Schaltvorrichtung ($Q_5$) mit einer zweiten gemeinsamen Ausgangsklemme ($O_2$) verbindet, an welche die Diodeneinrichtungen aller Testschaltkreise angeschlossen sind, und weiter gekennzeichnet durch eine Folgesteuermittel zum Betätigen der ersten, zweiten und dritten Schaltvorrichtungen, so daß alle einem einzigen Leiter zugeordneten schaltvorrichtungen gleichzeitig betätigt sind, wobei Signale, die an den ersten und zweiten, gemeinsamen Ausgangsklemmen auftreten, den Zustand jedes Leiters der Reihe nach anzeigen.

2. Apparatur nach Anspruch 1, bei welcher die dritte Schaltvorrichtung (S) eine Analogschaltvorrichtung ist, so daß eine Überprüfung des Leiterwiderstandes ausführbar ist.

3. Apparatur nach Anspruch 2, bei welcher die zweite gemeinsame Ausgangsklemme mit einem Spannungsfensterdetektor ($C_1$, $C_2$, 42, 45) verbunden ist, um abzufühlen, ob die dort anliegende Spannung innerhalb vorgeschreibener Grenzwerte liegt.

4. Apparatur nach einem der voranstehenden Ansprüche mit einem Folgesteuerspeicher, in dem Verbindungsdaten für alle Leiter des Kabelbaums gespeichert sind, so daß während des Testvorgangs "normale" und "verzweigte" Steuerschrittfolgen automatisch stattfinden.

5. Apparatur nach einem der voranstehenden Ansprüche, bei welcher ein Testergebnisspeicher vorgesehen ist, in dem Testergebnisse zumanschließenden Ablesen der Ergebnisse folgeweise speicherbar sind.

## Revendications

1. Appareil pour tester des faisceaux de câbles, comprenant plusieurs circuits d'essai, un pour chaque câble du faisceau, et comprenant chacun un premier dispositif de commutation ($Q_1$) pour relier un extrémité du câble associé à un pôle d'une alimentation en courant et un second dispositif de commutation ($Q_5$) pour relier l'autre extrémité dudit câble à l'autre pôle de l'alimentation en courant, caractérisé en ce que chaque circuit d'essai comprend également une résistance (R) pour la connexion entre ladite autre extrémité dudit câble et le second dispositif de commutation ($Q_5$), un troisième dispositif de commutation (S) reliant la jonction du câble et de la résistance (R) à une première borne de sortie commune ($O_1$) à laquelle sont reliés les troisièmes dispositifs de commutation (S) de tous les circuits d'essai, et un moyen à diode ($D_4$) reliant la jonction de la résistance (R) et du second dispositif de commutation ($Q_5$) à une seconde borne de sortie commune ($O_2$) à laquelle sont reliés les moyens à diodes de tous les circuits d'essai, et caractérisé également par la présence d'un moyen de commande séquentielle pour actionner les premier, second et troisième dispositifs de commutation de telle sorte que tous les dispositifs de commutation associés à un même câble sont simultanément actionnés, des signaux fournis auxdites première et seconde bornes de sortie communes indiquant tour à tour la condition de chaque câble.

2. Appareil selon la revendication 1, caractérisé en ce que ledit (lesdits) troisième(s) dispositf(s) de commutation est un dispositif de commutation analogique, de sorte qu'on peut tester la résistance du câble.

3. Appareil selon la revendication 2, caractérisé en ce que ladite seconde borne de sortie commune est reliée à un détecteur de fenêtre de tension ($C_1$, $C_2$, 42, 45), afin de détecter si la tension qui y est appliquée se situe dans des limites prescrites.

4. Appareil selon une quelconque des revendications précédentes, comprenant une mémoire de commande séquentielle dans laquelle sont enregistrées des données de connexion pour tous les câbles du faisceau, de sorte que la gradation séquentielle "état normal" et "état branché" peut avoir automatiquement lieu au cours de la procédure d'essai.

5. Appareil selon une quelconque des revendications précédentes, dans lequel il est prévu une mémoire de résultats d'essai permettant le stockage séquentiel de résultats d'essai en vue d'une sortie ultérieure des résultats.

FIG.I.

FIG.2.

FIG.3.

FIG.4.

FIG.5.

FIG.6.